# EUROPEAN PATENT APPLICATION

(11) **EP 1 544 634 A1**
(43) Date of publication of application: **22.06.2005**
(21) Application number: 04029329.2
(22) Date of filing: 10.12.2004
(51) Int. Cl.: G01R 33/465

(54) **In vitro method for characterizing the metabolic stability of a hyperpolarized drug candidate**

(30) Priority: 17.12.2003 NO 20035626
(71) Applicant: Amersham Health AS, 0401 Oslo (NO)
(72) Inventor: Lerche, Mathilde H., 205 12 Malmö (SE); Golman, Klaes, 205 12 Malmö (SE)
(74) Representative: Flechsler, Insa

(57) **Abstract**

The invention relates to an NMR based method for characterising the metabolic stability of a drug candidate comprising enhancing the nuclear polarisation of NMR active nuclei present in the drug candidate (hereinafter termed "hyperpolarisation") contacting the drug candidate with liver cells or cell organelles and carrying out NMR analysis.

## Description

The invention relates to an NMR based method for characterising the metabolic stability of a drug candidate comprising enhancing the nuclear polarisation of NMR active nuclei present in the drug candidate (hereinafter termed "hyperpolarisation") contacting the drug candidate with liver cells and carrying out NMR analysis.

The ability of an organism to absorb a drug, translocate it, change it (metabolise it) and finally remove it from the organism itself is crucial to how well a drug will operate in a particular organism or individual. For clinical trialing of a new drug as well as for the therapeutic efficacy of a drug it is important to gain better understanding of how a drug will perform in a human individual or a human population.

The majority of all drugs are metabolised via a small number of metabolic pathways that are dependent on enzymes located in the liver. One of these enzymes, cytochrome P 450 (CYP450) that is located in the endoplasmic reticulum of liver cells, plays a key role in the metabolism of drugs. The members of the CYP450 superfamily of oxidases show a common catalytic mechanism but individual isoenzymes have divergent substrate specificity. Other enzymes located in the liver are for instance flavin-monooxygenases, carboxylesterases, epoxide hydrolase, UDP-glucuronosyltransferases, sulfotransferases, methyltransferases, acetyltransferases, glutathione S-transferases, monoamine oxidase (MAO), rhodanese, N-acyltransferase and aldehyde dehydrogenase.

The metabolic stability of a potential drug candidate is one of the key criteria for drug candidate selection as it is closely linked to the therapeutic efficiency of the drug candidate. If the potential drug candidate shows a poor metabolic stability (i.e. it is efficiently metabolised), then steady-state drug levels will be sub-therapeutic which may lead to no drug effect at all. Hence such drug candidates are non-optimal therapeutic drugs.

The testing of a new drug in humans in a clinical trial is an expensive and protracted process. About 40% of the drugs undergoing clinical trials are withdrawn as a consequence of non-favourable pharmacokinetic properties, e.g. poor metabolic stability. The late failure of a putative drug has a significant impact on the profitability of the developer, while withdrawal of a drug after its launch on the open market has an even greater impact on the valuation and reputation of a pharmaceutical company.

Hence there is great interest in simple "screening-type" assay which can provide information about the metabolic stability of potential drug candidates before the drug candidate is used in a clinical trial.

The use of NMR based methods in metabolism studies is known. Generally, metabolism of drug or drug candidates is investigated *in vivo* using animal models by collecting samples like for instance blood or urine samples from animals that have received a certain dose of the drug. Drug metabolites are isolated from the samples and identified by NMR spectroscopy (see for example T. Koudriakova et al., J. Pharmacol Exp Ther. 1996, 279(3), 1300-1309). The disadvantage of this method is that isolation of the metabolites from the samples is time consuming process. Moreover, due to possible reduced recovery of the drug and its metabolites it might be difficult to detect small amounts of metabolites in the NMR analysis. A further disadvantage is that the study is carried out *in vivo,* which is not favourable for a "screening-type" assay.

K. Akira et al., Drug Metab Dispos 29, 2001, 903-907 describe the use of ¹³C-NMR spectroscopy to study the metabolism of ¹³C-labelled antipyrine by CYP450 isoenzymes in an *in vivo* assay. Due to the reduced sensitivity of conventional ¹³C-NMR spectroscopy, the drug has to be administered in large amounts leading to potential risk of adverse drug effects in the *in vivo* model.

WO-A-01/96895 describes a method for obtaining information regarding the fate of a test compound in a biological system by enhancing the nuclear polarisation of NMR active nuclei present in the test compound (hyperpolarisation) prior to NMR analysis.

WO-A- 03/089657 describes a method for phenotyping of a human individual. The human individual receives a probe compound (drug) and samples are collected from the individual, which are then hyperpolarised and analysed by NMR. As this method requires human beings, it is not possible to use it as a "screening type" assay to determine whether it may be useful to undergo a clinical trial with this drug.

We have now surprisingly found that an NMR based *in vitro* assay comprising hyperpolarising a drug candidate, contacting it with liver cells and acquiring an NMR spectrum of the drug candidate/liver cell mixture could be used to characterise the metabolic stability of said drug candidate.

Hence the present invention provides a method for characterising the metabolic stability of at least one drug candidate *in vitro* comprising hyperpolarising the drug candidate, contacting it with liver cells or liver cell organelles to form a mixture and acquiring an NMR spectrum of the mixture.

The fact that the method according to the invention is a rapid and simple *in vitro* assay makes it especially suitable for the screening of large numbers of potential drug candidates. Thus, the method could prevent unnecessary and costly clinical trials. In favour of this method is further that the *in vitro* metabolism of the drug candidate in liver cells or cell organelles allows for the prediction of *in vivo* metabolism of said drug candidate. The method according to the invention does not require time consuming isolation of the drug candidate and/or its metabolites from assay materials. Further, due to the use of hyperpolarised drug candidates the sensitivity of the method is superior to a "normal" NMR based assay which, in turn, allows for the detection of only small amounts of metabolites which are not detectable by conventional NMR.

In the context of the invention, a drug candidate may be any chemical entity, preferably a relatively small organic molecule, more preferably a small organic molecule of less than 200 Da. The drug candidate may be a naturally derived chemical entity, e.g. obtainable by isolation from natural or genetically modified organisms like for instance microorganisms, plants, animals or human beings. Such naturally derived chemical entities may further be modified, e.g. by the reaction with enzymes or other chemical compounds. The drug candidate may as well be a synthetic or semi-synthetic chemical entity.

Either one single drug candidate or a mixture of drug candidates may be used in the method according to the invention. The number of drug candidates in a mixture of drug candidates is not critical. However, when a mixture of drug candidates is used, the drug candidates are preferably selected in such a way that they and their metabolites show a well-dispersed NMR spectrum in order to distinguish clearly between the different drug candidates and their metabolites.

The drug candidate used in the method according to the invention must contain at least one NMR active nucleus, i.e. a nucleus with non-zero nuclear spin. Preferred nuclei are ¹³C, ¹⁵N, ³¹P, ¹⁹F, and/or ¹H. Isotopically enriched drug candidates may be employed in the method, more preferably drug candidates enriched with nonradioactive isotopes. The isotopic enrichment has substantially no effect on the metabolic stability of the drug candidate and the NMR detection is strongly facilitated. However, isotopic enrichment may be less practical for the use of the method in high throughput screening, as isotopic enrichment is costly and requires time.

If the drug candidate is isotopically enriched, the enrichment may include either selective enrichments of one or more sites within the drug candidate molecule or uniform enrichment of all sites. Preferably, the drug candidate is isotopically enriched in only one position of the molecule. Enrichment can for instance be achieved by chemical synthesis or biological labelling. Preferably, a drug candidate for use in the method according to the invention is isotopically enriched in only one position of the molecule with an enrichment of at least 10%, most suitably at least 25%, preferably at least 75%, most preferably at least 90%, ideally approaching 100%.

If the drug candidate is isotopically enriched, the drug candidate is enriched with ¹³C and/or ¹⁵N, preferably with ¹³C or ¹⁵N, particularly preferred with ¹³C . The optimal position for isotopic enrichment in the drug candidate molecule is dependent on the relaxation time of the NMR active nuclei. Preferably, drug candidates are isotopically enriched in positions with long T1 relaxation time. In a preferred embodiment, ¹³C enriched drug candidates enriched at a carboxyl, a carbonyl or a quaternary C-atom are used.

There are several ways for hyperpolarising the drug candidates used in the method of the invention. Preferred ways are polarisation transfer from a noble gas, "brute force", the parahydrogen method, DNP and spin refrigeration, all explained below.

A preferred way for hyperpolarising the drug candidate is the polarisation transfer from a hyperpolarised noble gas. Noble gases having non-zero nuclear spin can be hyperpolarised, i.e. have their polarisation enhanced over the equilibrium polarisation, e.g. by the use of circularly polarised light. A hyperpolarised noble gas, preferably ³He or ¹²⁹Xe, or a mixture of such gases, may be used according to the present invention to effect hyperpolarisation of the NMR active nuclei present in the drug candidate. The hyperpolarisation may also be achieved by using an artificially enriched hyperpolarised noble gas, preferably ³He or ¹²⁹Xe. The hyperpolarised gas may be in the gas phase, it may be dissolved in a liquid, or the hyperpolarised gas itself may serve as a solvent. Alternatively, the gas may be condensed onto a cooled solid surface and used in this form, or allowed to sublime. Either of these methods may allow the necessary intimate mixing of the hyperpolarised gas with the molecule to be hyperpolarised. In some cases, liposomes or microbubbles may encapsulate the hyperpolarised noble gas.

Another preferred way for hyperpolarising the drug candidate is that polarisation is imparted to the NMR active nuclei in the drug candidate molecules by thermodynamic equilibration at a very low temperature and high field. Hyperpolarisation compared to the operating field and temperature of the NMR spectrometer is effected by use of a very high field and very low temperature (brute force). The magnetic field strength used should be as high as possible. Suitably the magnetic field strength is higher than 1 T, preferably higher than 5 T, more preferably 15 T or more and especially preferably 20 T or more. The temperature should be very low, e.g. 4.2 K or less, preferably 1.5 K or less, more preferably 1.0 K or less, especially preferably 100 mK or less.

Another preferred way for hyperpolarising the drug candidate is the parahydrogen method. An unsaturated precursor of the drug candidate comprising hydrogenatable carbon-carbon double- or triple bonds is exposed to parahydrogen-enriched hydrogen gas in the presence of a suitable catalyst. The enriched hydrogen will then react with the precursor imparting a non-thermodynamic spin configuration to the target molecule. The parahydrogen method is described in detail in WO-A-99/24080 and WO-A-00/71166, both incorporated by reference herein.

Another preferred way for hyperpolarising the drug candidate is the DNP (dynamic nuclear polarisation) method effected by a DNP agent. DNP mechanisms include the Overhauser effect, the solid effect and the thermal mixing effect. Many known paramagnetic compounds may be used as DNP agents, e.g. transition metals such as chromium (V) ions, organic free radicals such as nitroxide radicals and trityl radicals (WO-A-98/58272) or other molecules having associated free electrons. Preferably, radicals with low relaxivity are used as DNP agents. Where the DNP agent is a paramagnetic free radical, the radical may be conveniently prepared *in situ* from a stable radical precursor by a radical-generating step shortly before the polarisation, or alternatively by the use of ionising radiation. During the DNP process, energy, normally in the form of microwave radiation, is provided, which will initially excite the paramagnetic species. Upon decay to the ground state, there is a transfer of polarisation to the NMR active nuclei of the target material. The method may utilise a moderate or high magnetic field and very low temperature, e.g. by carrying out the DNP process in liquid helium and a magnetic field of about 1 T or above. Alternatively, a moderate magnetic field and any temperature at which sufficient NMR enhancement is achieved in order to enable the desired studies to be carried out may be employed. The method may be carried out by using a first magnet for providing the polarising magnetic field and a second magnet for providing the primary field for MR spectroscopy. Alternatively, both DNP polarisation and NMR spectroscopy may be carried out in a single magnet.

Another preferred way for hyperpolarising the drug candidate is the spin refrigeration method. This method covers spin polarisation of a solid compound or system by spin refrigeration polarisation. The system is doped with or intimately mixed with suitable paramagnetic materials such as Ni²⁺, lanthanide or actinide ions in crystal form with a symmetry axis of order three or more. The instrumentation is simpler than required for DNP with no need for a uniform magnetic field since no resonance excitation field is applied. The process is carried out by physically rotating the sample around an axis perpendicular to the direction of the magnetic field. The pre-requisite for this method is that the paramagnetic species has a highly anisotropic g-factor. As a result of the sample rotation, the electron paramagnetic resonance will be brought in contact with the nuclear spins, leading to a decrease in the nuclear spin temperature. Sample rotation is carried out until the nuclear spin polarisation has reached a new equilibrium.

The DNP method is the most preferred method for hyperpolarising the drug candidate according to the invention.

Some of the hyperpolarisation techniques described above, e.g. DNP, brute force or spin refrigeration transfer, are advantageous when transferring polarisation to a sample in the solid state. If the drug candidate sample is not solid, it may conventionally be frozen in an appropriate solvent or solvent mixture prior to hyperpolarisation by one of the methods that need to be carried out in the solid state. Solvent mixtures have been found to be particularly suitable, especially if the mixture forms an amorphous glass, e.g. mixtures comprising glycerol, propanediol or glycol. Such an amorphous matrix is preferably employed in DNP hyperpolarisation to ensure homogenous distribution of the drug candidate in the solid.

The polarisation of the NMR active nuclei in the drug candidate molecules can be measured by its enhancement factor compared to thermal equilibrium at the spectrometer field and temperature. Suitably, the enhancement factor for any NMR active nucleus is at least 10, preferably at least 50 and more preferably at least 100.

If hyperpolarisation is carried out by a method that requires the drug candidate sample to be in the solid state, drug candidate sample is preferably brought into solution or suspension after the hyperpolarisation step. Suitable solvents are those which do not interfere with the interaction between the drug candidate and the enzymes present in the liver cells that are involved in the metabolism of the drug candidate. Such solvents are for example non-deuterated and deuterated buffers, like phosphate buffers and they may contain small amounts of organic solvents such as DMSO and methanol.

The amount of hyperpolarised drug candidate is not critical. However, due to the sensitivity of the method according to the invention, the metabolic stability of drug candidates can be determined using therapeutic doses of these drug candidates thus mimicking the *in vivo* situation in patient.

In the method according to the invention, the at least one hyperpolarised drug candidate is contacted with liver cells or liver cell organelles to form a mixture.

Suitably, liver cells used in the method according to the invention may be in the form of liver tissue, primary cell cultures derived from liver tissue or liver cell lines, such as immortalized hepatocytes. Liver tissue in its homogenized form as well as liver slices may be used in the method of the invention. Primary liver cell cultures include primary hepatocytes or Kupffer cells, with hepatocytes being preferred. Preferred liver cell organelles are liver microsomes, liver mitochondria and liver S9 fraction. Liver S9 fraction is the term for the post-mitochondrial supernatant fraction, which contains both cytosol and microsomes. Microsomes can be isolated by ultracentrifugation (104000 g for one hour) of the S9 fraction. In a preferred embodiment, the liver cells and liver cell organelles used in the method according to the invention are of mammalian origin, more preferably they are human liver cells or liver cell organelles.

Contacting the liver cells or cell organelles with the at least one hyperpolarised drug candidate may be carried out in several ways. Suitably, the liver cells are placed into an NMR tube and the hyperpolarised drug candidate is mixed into the liver cells. Mixing may be promoted by various means like vortexing, sonification, stirring etc. In another preferred embodiment, liver cells or cell organelles are mixed into a solution or suspension of the hyperpolarised drug candidate.

In a preferred embodiment, the mixture of liver cells or cell organelles and hyperpolarised drug candidate is incubated for a short while, e.g. for about 10 to 30 s.

The NMR spectrum acquired from the mixture of liver cells or cell organelles and hyperpolarised drug candidate may be a one-, two- or multidimensional NMR spectrum, preferably a one-dimensional NMR spectrum of the nucleus of choice, like ¹³C, ¹⁵N, ¹⁹F, ³¹P or ¹H. The spectrum may be acquired in a single scan or in several scans in any combination of RF and gradient pulses, depending on the NMR parameters to be extracted and the information to be obtained. Such parameters are for example chemical shift, line broadening, dipolar or scalar couplings. In a preferred embodiment, low flip angels are used in the generation of the NMR spectrum. Thus, it is possible to study the time dependent metabolic breakdown of the drug candidate.

In a preferred embodiment, the NMR spectrum obtained from the drug candidate according to the method of the invention is subsequently compared with an NMR spectrum of the hyperpolarised drug candidate which has not been brought into contact with liver cells or cell organelles, e.g. which is not metabolised (reference spectrum). The conditions for acquiring said reference spectrum should be as close to the conditions of generating the NMR spectrum according to the method of the invention. Preferably, the conditions are identical with respect to e.g. addition of solvents, pH and spectral parameters like for instance pulse length. The reference spectrum may be a one-, two- or multidimensional NMR spectrum, preferably a one-dimensional NMR spectrum of the nucleus of choice, e.g. ¹³C, ¹⁵N; ³¹P, ¹⁹F or ¹H. The spectrum may be acquired in a single scan or in several scans in any combination of RF and gradient pulses.

Comparison may be done by mere visual assessment of the spectra, e.g. if a peak has appeared or disappeared. Suitably, comparison is carried out in a computer-assisted way, e.g. by calculating a difference spectrum between the NMR spectrum generated in the method of the invention and the reference spectrum. Preferably, chemical shift changes, line broadening, relaxation time differences or NOE effect differences may be monitored.

In another preferred embodiment, it would not be necessary to acquire a reference spectrum of the drug candidate as the information is contained in the spectrum acquired from the mixture. For instance, if the drug candidate is not completely metabolised, it is still present in the mixture and thus visible in the spectrum acquired from the mixture.

### Examples

Drug candidate: ¹³C₂-sodiumfumerate

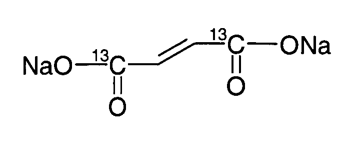

### 1.1. Preparation of the hepatocyte suspension

The concentration of hepatocytes was 1•10⁶ cells/ml in a suspension of RPMI 1640 medium. 1 ml of this suspension was placed in a 10 mm NMR tube with a bottom plug, reducing the active volume to 1100 µl. The tube was placed in a 9.4 T magnet with the temperature of the probe equilibrated to 37 °C. A tube was connected to the bottom of the NMR tube to allow for injection of the hyperpolarised drug candidate solution into the cell suspension.

### 1.2 Hyperpolarisation of the drug candidate and formation of the cell suspension/drug candidate mixture

¹³C₂-sodiumfumerate was diluted in water and mixed (1:1 w/w) with a glycerol solution containing 40 mM trityl. The liquid sample was frozen as droplets in liquid nitrogen. 84.3 mg of this sample (3.84 mg of ¹³C₂-sodiumfumerate) was placed in the polariser and hyperpolarised for two hours at 93.945 GHz and 100 mW (DNP method). The dissolution was performed with Tris buffer containing 100 mg/l EDTA (pH 7.4, 20 mM, 6 ml). The active dissolution volume was 5.5 ml with full recovery of the sample. A 1 ml syringe was filled completely (volume: 1100 µl) with the dissolved ¹³C₂-sodiumfumerate solution, a total of 100 µl of this solution was quickly transferred to the liquid-NMR magnet and injected into the cell suspension, resulting in a total drug candidate concentration of approximately 0.46 mM.

### 1.3 Acquisition of an NMR spectrum of the mixture

A 1D ¹³C NMR-spectrum was acquired after a 30 s incubation period with a 10 mm Varian direct detection probe at 100.393 MHz (400 MHz, ¹H), with the probe at 37 °C The NMR acquisition parameters were a spectral width of 40 kHz (400 ppm), an acquisition time of 1 s, and a pulse angle of 90°. One NMR signal was obtained at 174.8 ppm from the ¹³C-labelled drug candidate. This signal originates from the two labelled positions in this drug candidate molecule. Three additional signals were observed, one at 182.3 ppm and two at 181.2 ppm and 179.9 ppm. These signals originate from two different metabolites of the drug candidate, namely succinate and malate. In malate the two labelled carbon atoms are no longer in a similar environment giving rise to different chemical shifts.

In this example an incubation period of 30 s was kept before the spectrum was acquired. Another way of obtaining information on the metabolites would be to acquire continues sets of spectra over time with a reduced flip angle.

## Claims

1. Method for characterising the metabolic stability of at least one drug candidate *in vitro* comprising hyperpolarising the drug candidate, contacting it with liver cells or liver cell organelles to form a mixture and acquiring an NMR spectrum of the mixture.

2. Method according to claim 1 wherein one drug candidate is used.

3. Method according to claim 1 wherein more than one drug candidate is used.

4. Method according to claims 1 to 3 wherein the at least one drug candidate is isotopically enriched

5. Method according to claim 4 wherein the at least one drug candidate is isotopically enriched in only one position of the molecule.

6. Method according to claims 4 and 5 wherein the at least one drug candidate is enriched with ¹³C or ¹⁵N.

7. Method according to claim 6 wherein the at least one drug candidate is enriched with ¹³C.

8. Method according to claims 1 to 8 wherein hyperpolarisation is carried out by dynamic nuclear polarisation (DNP).

9. Method according to claim 9 wherein the at least one hyperpolarised drug candidate is brought into solution or suspension before contacting it with the liver cells.

10. Method according to claims 1 to 10 wherein the liver cells are in the form of liver tissue, primary cell cultures derived from liver tissue or liver cell lines and the liver cell organelles are liver microsomes, liver mitochondria or liver S9 fraction.

11. Method according to claims 1 to 11 wherein the NMR spectrum generated is a one-or two-dimensional NMR spectrum, preferably a one-dimensional NMR spectrum.

12. Method according to claims 1 to 12 wherein the NMR spectrum is acquired in a single scan

13. Method according to claims 1 to 12 wherein the NMR spectrum is acquired in several scans.
